# EUROPEAN PATENT SPECIFICATION

(11) **EP 4 471 823 B1**
(45) Date of publication and mention of the grant of the patent: **06.05.2026**
(21) Application number: 23202403.4
(22) Date of filing: 09.10.2023
(51) Int. Cl.: H01J 37/32

(54) **PLASMA TREATMENT APPARATUS**
PLASMABEHANDLUNGSGERÄT
APPAREIL DE TRAITEMENT AU PLASMA

(30) Priority: 02.06.2023 JP 2023091634
(43) Date of publication of application: 04.12.2024
(73) Proprietor: Plasma Ion Assist Co., Ltd., Kyoto-shi, Kyoto 612-8373 (JP)
(72) Inventor: WATANABE, Masanori, Katano-shi, Osaka, 576-0021 (JP); SUZUKI, Yasuo, Otsu-shi, Shiga, 520-0225 (JP)
(74) Representative: Müller Hoffmann & Partner

(56) References cited:
- CN-A- 114 765 103
- JP-A- 2016 072 258
- JP-B2- 7 202 641
- US-A1- 2016 099 130
- US-A1- 2022 336 188

## Description

### CROSS-REFERENCE TO RELATED APPLICATION

This application claims the priority benefit of Japan application serial no. 2023-091634, filed on June 2, 2023.

### BACKGROUND

### Technical Field

The disclosure relates to a plasma treatment apparatus capable of continuously performing a plurality of plasma treatment processes.

### Related Art

Patent Document 1 (Japanese Patent No. 5747231) discloses a plasma treatment apparatus having a plate-shaped high frequency antenna conductor attached to cover an opening portion formed in a wall surface of a vacuum container with airtightness, and configured to feed high frequency electric power to one end portion of the antenna conductor in a longitudinal direction, directly ground the other end portion to flow high frequency current thereto, generate plasma using an induced electromagnetic field generated in the vicinity of the antenna conductor, and perform plasma treatment on a substrate to be treated using the plasma. In addition, Patent Document 2 (Japanese Patent Application Laid-Open No. 2016-149287) discloses a plasma treatment apparatus in which two main and subsidiary antenna conductors are provided.

Plasma treatment processes of a substrate material by a plasma treatment apparatus include a plurality of plasma treatment processes such as a cleaning process of a substrate surface, an ion implantation process, a forming process of a diamond-like carbon (hereinafter, also referred to as DLC) film, and the like. In these processes, it is necessary to perform plasma treatment while a treated base material is irradiated with ions as negative potential for plasma potential of discharge plasma. In the plasma treatment apparatus disclosed in Patent Documents 1 and 2, ion irradiation is performed by applying a negative DC voltage or a negative pulse voltage for plasma potential to the treated base material.

However, for example, in the plasma treatment apparatus having a plurality of plasma treatment processes by a roll-to-roll method, since the base material and the conveyance system as a whole have the same negative potential, for example, if the treatment conditions for each plasma treatment chamber are changed, the configuration of the device becomes complicated, expensive, and impractical.
CN 114 765 103 A discloses an in-line plasma processing apparatus for treating a plurality of substrates, said substrates being transported by a conveying mechanism and conveying belt through a plurality of plasma processing chambers. These chambers are connected to each other, and different exhaust chambers are disposed between adjacent processing chambers. The processing chambers may be maintained at a predetermined degree of vacuum without the need to install gate valves between them.
JP 2016 072258 A discloses a plasma etching apparatus wherein a grounded substrate is transported under an ICP source by a transport mechanism. The ICP source comprises inductively coupled antennae for generating a plasma in the vacuum chamber, a partition that defines a plasma processing space, and an acceleration unit former of first and second bias electrodes, which are arranged on the upstream and downstream sides of the processing space along the transport direction. The two electrodes are effectively disposed around the plasma generation region, and are biased so as to extract ions or electrons and so as to accelerate these charged particles towards the grounded substrate. Heat generated radiates towards the substrate through the processing space.

US 2022/0336188 A1 discloses a treatment system, which comprises a process chamber for dynamic or static treatment of at least one substrate. An inductively coupled plasma source comprises at least one inductor extending along the longitudinal direction of the ICP source, a gas supply device for one or a plurality of process gases, and a gas directing arrangement disposed in the process chamber, said gas directing arrangement extending along the longitudinal direction of the ICP source and partially surrounding the at least one inductor.

### SUMMARY

The invention is defined by the claims. An embodiment of the disclosure provides a plasma treatment apparatus including: a plasma treatment chamber (hereinafter, also simply referred to as a treatment chamber) in which a treated base material is accommodated; a conveyance part which conveys the treated base material into the plasma treatment chamber; an inductive coupling linear antenna (hereinafter, also simply referred to as a linear antenna) configured to generate plasma; a bias electrode which applies a bias voltage to the plasma; and a heating part which heats the treated base material. A cross section of the bias electrode cut perpendicularly to a longitudinal direction has a dome-shaped or U-shaped box shape, and the inductive coupling linear antenna and the heating part are disposed substantially in parallel in the bias electrode in the longitudinal direction of the bias electrode.

Accordingly, the plasma potential of the discharge plasma generated by the linear antenna can be controlled, and simultaneously, a diffusion region of the discharge plasma can be confined in the bias electrode.

Then, since the treated base material at the ground potential can be irradiated with ions by applying a positive bias potential to the plasma via the bias electrode, the plasma treatment can be performed on the surface of the object to be treated while holding the treated base material and the conveyance system at the ground potential.

Further, for example, the plurality of plasma treatment processes having different treatment conditions can be continuously performed by controlling the bias potential applied to the bias electrode for each treatment chamber. Furthermore, it is effective in reducing the cost of the apparatus and improving safety by keeping the treated base material and the conveyance system at the ground potential.

The plasma treatment apparatus according to an embodiment of the disclosure includes a vacuum exhaust part configured to vacuum-exhaust the inside of the treatment chamber and a gas introduction part configured to introduce a working gas, and introduces the working gas according to the plasma treatment process.

According to the above-mentioned configuration, an appropriate gas pressure, for example, 1 Pa, in the treatment chamber can be adjusted by the gas introduction part.

In an embodiment of the disclosure, the bias electrode may be a structure that surrounds the plasma generation region.

According to the above-mentioned configuration, the object to be treated can be efficiently irradiated with the ions in the plasma.

In an embodiment of the disclosure, the linear antenna passes through a quartz tube via a vacuum seal member at an opening portion formed in a sidewall surface of the plasma treatment chamber, and an inductive coupling antenna conductor (hereinafter, also simply referred to as an antenna conductor) is accommodated in the quartz tube.

According to the above-mentioned configuration, high density discharge plasma can be excited in the treatment chamber by supplying high frequency electric power to the antenna conductor.

In an embodiment of the disclosure, the bias electrode has a lidless box shape in which a cross section perpendicular to the longitudinal direction is a dome shape or a U shape, and the linear antenna and the heating part are disposed in the bias electrode substantially in parallel with the longitudinal direction of the bias electrode.

According to the above-mentioned configuration, the positive bias voltage can be applied to the discharge plasma, and the plasma treatment can be performed on the surface of the treated base material located at the ground potential.

In an embodiment of the disclosure, the linear antenna may be a single rod-shaped antenna conductor, or may be a U-shaped antenna conductor that constitutes a round-trip circuit for high frequency current. The discharge plasma generated by the high frequency discharge is confined in a space (discharge region) surrounded by the bias electrode and the treated base material.

According to the above-mentioned configuration, discharge in an unnecessary region in the treatment chamber can be suppressed, and dust or the like generated in the treatment chamber can be reduced.

In an embodiment of the disclosure, the bias voltage is a DC voltage, a pulse voltage, or a pulsating current voltage obtained by half-wave rectifying an AC voltage according to plasma treatment content.

In an embodiment of the disclosure, in the heating part, for example, since a heating lamp heater is disposed in the bias electrode, most radiant heat radiated from the heating part is absorbed by the bias electrode and the treated base material.

Accordingly, when a metal material having large thermal emissivity on the inner surface and small thermal emissivity on the outer surface, for example, an aluminum material or the like, is used as the bias electrode, the treated base material can be effectively heated.

In addition, in an embodiment of the disclosure, the outer surface of the bias electrode may be coated with an insulator film, for example, an aluminum oxide or silicon oxide film.

According to the above-mentioned configuration, unnecessary abnormal discharge between the bias electrode and a peripheral member located at a ground potential can be suppressed.

Further, in an embodiment of the disclosure, a plurality of opening portions may be provided in the wall surface of the treatment chamber, and the plurality of linear antennas and heating parts may be disposed substantially in parallel.

The treatment area of the treatment chamber can be enlarged and uniform surface treatment can be achieved.

According to an embodiment of the disclosure, the plasma treatment apparatus is an in-line type plasma treatment apparatus in which the plurality of plasma treatment chambers are connected, and front and rear sides of the plasma treatment chamber may be connected via a differential exhaust chamber connected to a differential exhaust system.

According to the above-mentioned configuration, the plurality of plasma treatment processes having different treatment conditions can be continuously performed, and effects according to the disclosure can be more remarkably exhibited.

According to the plasma treatment apparatus according to the embodiments of the disclosure, the treated base material can be held at the ground potential, and different plasma treatment can be achieved by changing the bias voltage applied to the bias electrode. In the case of one treatment chamber, the plurality of treatment processes can be executed sequentially in time, and when the plurality of treatment chambers are connected, the plurality of treatment processes according to the in-line type can be performed in parallel. In particular, in the roll-to-roll type plasma treatment apparatus having the plurality of treatment processes, different plasma treatment is possible for each treatment chamber. By locating both the treated base material and the conveyance system at the ground potential, the plasma treatment apparatus can be simplified, the manufacturing cost can be reduced, and the handling safety can be significantly improved.

In addition, in the plasma treatment apparatus according to the embodiments of the disclosure, the utilization efficiency of radiant heat can be significantly improved by placing the heating part for heating the treated base material within the bias electrode.

That is, according to the plasma treatment apparatus of the embodiments of the disclosure, the plasma treatment can be performed while irradiating high energy ions by grounding the treated base material and applying the positive bias voltage to the bias electrode to perform positive potential plasma treatment without applying a high frequency voltage or a pulse voltage to the treated base material located at the ground potential.

### BRIEF DESCRIPTION OF THE DRAWINGS

FIG. 1 is a schematic cross-sectional view showing an embodiment of a plasma treatment apparatus of the disclosure.
FIG. 2 is a schematic view showing an embodiment of a plasma treatment chamber according to the disclosure.
FIG. 3 is a schematic view showing an embodiment of the plasma treatment chamber according to the disclosure.
FIG. 4 is a schematic cross-sectional view of a bias electrode, a linear antenna and a heating heater.
FIG. 5 is a schematic view showing a mounting method of the linear antenna.

### DESCRIPTION OF THE EMBODIMENTS

Embodiments of the disclosure provide an inexpensive and safe plasma treatment apparatus having a configuration that enables plasma treatment while holding a treated base material and a conveyance system at a ground potential, and capable of continuously performing a plurality of plasma treatment processes having different treatment conditions.

Hereinafter, an embodiment of a plasma treatment apparatus according to the disclosure will be described with reference to the accompanying drawings.

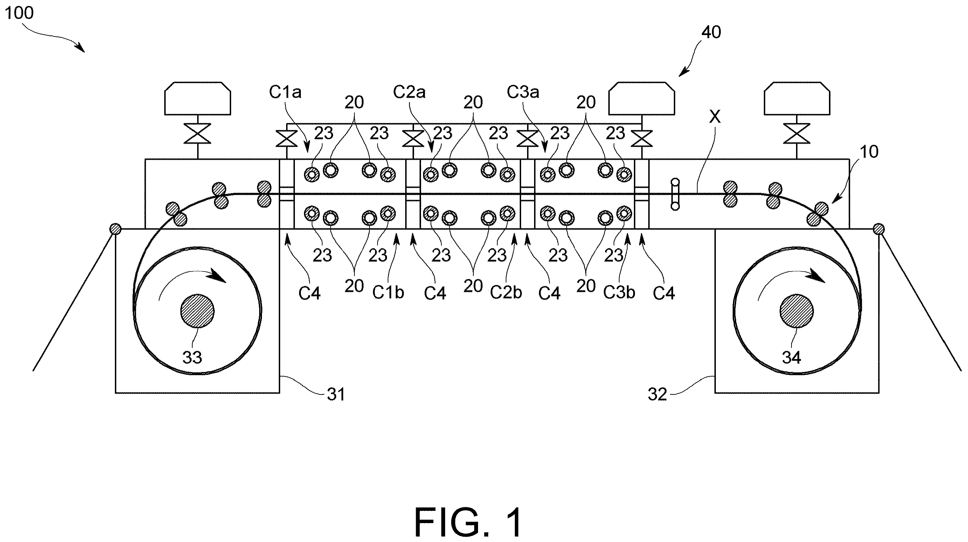

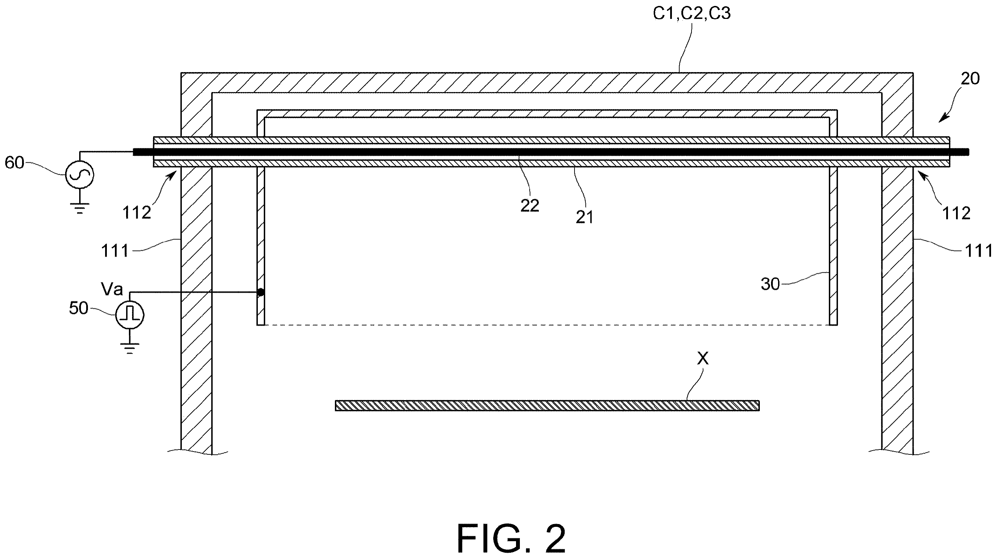

A configuration of a plasma treatment apparatus 100 of the embodiment is shown in FIG. 1. The plasma treatment apparatus 100 is a so-called roll-to-roll type plasma treatment apparatus in which a plurality of plasma treatment chambers C1, C2 and C3 can be connected to continuously perform a plurality of plasma treatment processes. For example, different plasma treatment can be simultaneously performed in parallel in each of the treatment chambers C1, C2 and C3 while a sheet-shaped treated base material X such as aluminum or the like is conveyed in the treatment chambers C1, C2 and C3 at a fixed speed. Further, while FIG. 1 shows the plasma treatment apparatus 100 having treatment chambers C1a, C2a and C3a disposed on a front surface side of the treated base material X and treatment chambers C1b, C2b and C3b disposed on a back surface side to perform plasma treatment on both surfaces of the treated base material X simultaneously, the treatment chambers may be disposed only on a single surface side of the treated base material X. Here, as a representative example for simplifying the description, a configuration of the treatment chamber C1a will be specifically described with reference to FIG. 2 to FIG. 4.

The plasma treatment apparatus 100 includes, as shown in FIG. 1 to FIG. 4, a conveyance part 10 configured to convey the treated base material X in the treatment chambers C1, C2 and C3 that are located at a ground potential, a linear antenna 20 configured to generate plasma, a bias electrode 30 configured to confine discharge plasma in a plasma generation region and apply a bias voltage to the plasma, and a heating part 23.

In addition, the plasma treatment apparatus 100 of the embodiment has the U-shaped elongated linear antenna 20 through which high frequency current flows. For example, a high frequency voltage of 13.56 MHz is supplied to one end portion of the U-shaped antenna conductor, and high density and high frequency discharge plasma is excited in the vicinity of a linear antenna conductor by grounding the other end portion and supplying power thereto. For example, a positive pulse voltage of 30 kHz or a low frequency AC voltage can be applied to the bias electrode 30 to perform plasma treatment on the surface of the treated base material X that is located at the ground potential.

The plasma treatment apparatus 100 of the embodiment is a so-called inductive coupling plasma (ICP) type configured to generate discharge plasma using an electromagnetic field generated by flowing high frequency current to the inductive coupling antenna.

The bias electrode 30 that surrounds the linear antenna 20 is a box structure having an opening surface disposed to face the treated base material X and surrounding a plasma generating region. The inside of the treatment chambers C1, C2 and C3 is held at a predetermined vacuum degree by a vacuum exhaust part (not shown) and a gas introduction part. For example, a mixed gas of argon and hydrogen is introduced and adjusted to a predetermined pressure, for example, 1 Pa. High frequency electric power is supplied to the linear antenna 20, and high density plasma is excited between the linear antenna 20 and the sheet-shaped base material X located at the ground potential. The surface of the treated base material X can be cleaned by applying a bias voltage of, for example, +2 kV to the bias electrode 30.

In the plasma treatment apparatus 100 of the embodiment, the treated base material X is grounded, the discharge plasma is filled in a space (i.e., a plasma generation region) provided between the linear antenna 20 and the treated base material X, and the plasma potential is the potential of the treated base material X, i.e., the ground potential. In order to perform the plasma treatment on the treated base material X, it is necessary to apply a bias voltage of, for example, +2 kV to the bias electrode 30 to make the plasma potential positive.

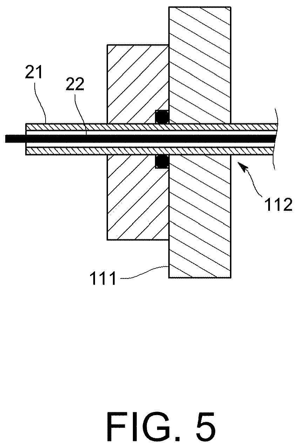

Circular opening portions 112 are formed in sidewalls 111 facing each other of the treatment chambers C1, C2 and C3, and as shown in FIG. 5, the linear antenna 20, which will be described below, is mounted in the opening portion 112. A quartz tube 21 is fitted into the opening portion 112, and thus the inside of the treatment chambers C1, C2 and C3 is configured to be closed.

The linear antenna 20 is disposed to face the treated surface of the treated base material X conveyed in the treatment chambers C1, C2 and C3, and specifically, as shown in FIG. 2, has a structure in which the quartz tube 21 is mounted to pass through the opening portions 112 formed in the sidewalls 111 facing each other of the treatment chambers C1, C2 and C3, and an antenna conductor 22 is mounted in the quartz tube 21. The quartz tube 21 is mounted to close the inside of the treatment chamber via a vacuum seal member provided in a sidewall plate of the treatment chamber, for example, an O ring or the like. The elongated linear antenna conductor 22 is mounted in the quartz tube 21, one end portion is connected to a high frequency power supply 60, and the other end portion is grounded.

Since the inside of the quartz tube 21 is under atmospheric pressure, no abnormal discharge occurs due to high frequency electric power feeding. In addition, since the antenna conductor 22 is inside the quartz tube 21, it does not come into direct contact with the discharge plasma, and there is no risk of contamination with impurities or the like due to sputtering of the antenna conductor 22.

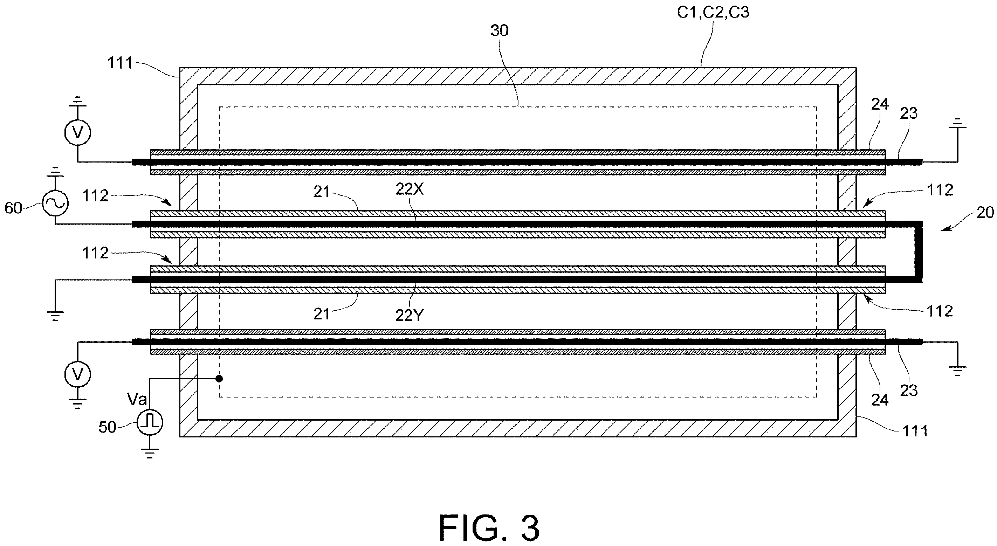

As shown in FIG. 3, the U-shaped antenna conductor 22 configured by bending one metal pipe is inserted into the quartz tubes 21. One end portion of one of long sides of the antenna conductor (hereinafter, also referred to as a power-feed-side antenna conductor 22X) is connected to a power feed terminal, and an end portion of the other (hereinafter, also referred to as a ground-side antenna conductor 22Y) is grounded.

In the embodiment, the high frequency current supplied to one end portion of the U-shaped antenna conductor flows through the power-feed-side antenna conductor 22X, makes a U-turn at the end portion, flows backward through the ground-side antenna conductor 22Y, and flows toward the ground terminal. Accordingly, an orientation of the high frequency current flowing through the power-feed-side antenna conductor 22X is opposite to an orientation in which the high frequency current flowing through the ground-side antenna conductor 22Y flows.

That is, the antenna conductor 22 configures a round-trip circuit with respect to the high frequency current supplied to one terminal of the power-feed-side antenna conductor 22X in a longitudinal direction. In such a round-trip circuit, mutual inductance occurs between round-trip antenna conductors, and the impedance of the antenna conductor 22 with respect to the high frequency current is reduced by cancelling out the corresponding amount of the mutual inductance.

Since the impedance of the antenna conductor 22 having such a configuration is reduced by canceling out the corresponding amount of the mutual inductance, an elongated antenna, for example, a linear antenna of 1 m or more, can be put into practical use.

In addition, in the linear antenna 20 according to the disclosure, the power-feed-side antenna conductor 22X and the ground-side antenna conductor 22Y are disposed substantially in parallel along an inner side surface of the bias electrode 30, the high frequency currents flowing to both the antenna conductors 22X and 22Y are opposite to each other, and the maximum electromagnetic field is generated between the antenna conductors 22X and 22Y. The linear antenna 20 of the disclosure is a configuration that can make the most effective use of this strong electromagnetic field and is extremely effective in generating high density plasma. In addition, discharge is likely to occur even in the low gas pressure region, and stable discharge plasma is maintained.

While the material of the antenna conductor 22 is not particularly limited, in order to supply high frequency electric power, for example, high frequency electric power of 13.56 MHz, in an embodiment, a metal material with good conductivity such as a copper material, an aluminum material, or the like is preferable.

### [Water cooling]

In addition, since the antenna conductor 22 is heated to several 100°C when high frequency current flows therethrough, in an embodiment, it is preferably a metal pipe capable of cooling such as water cooling. When a metal pipe such as a copper pipe, an aluminum pipe, or the like, is used as the antenna conductor 22, the antenna conductor 22 can be cooled by flowing coolant such as water or the like therethrough. According to the embodiment, since it is the U-shaped antenna conductor 22, cooling water can be injected from the power-feed-side and discharged from the ground-side.

### [Another antenna]

While the U-shaped antenna conductor 22 has been described in the embodiment, it may be a high frequency antenna having a structure in which power is supplied to one end portion of one elongated antenna conductor in the longitudinal direction and the other end portion is grounded. In addition, it may be a high frequency antenna having a structure in which power is supplied to a central portion of an elongated antenna conductor in the longitudinal direction, and both end portions are grounded.

Since the embodiment is characterized by the bias electrode 30, hereinafter, the bias electrode will be described in detail.

In the embodiment, a surface area of the bias electrode 30 is equal to or greater than a surface area of the treated base material X located at the ground potential, and the potential of the discharge plasma changes following the potential of the bias electrode 30 that surrounds the plasma. As shown in FIG. 2, the bias electrode 30 is connected to a positive bias power supply 50. When a positive bias voltage Va is applied to the bias electrode 30, the potential of the discharge plasma also becomes a positive bias potential Va. An ion sheath with the potential difference Va occurs on the surface of the treated base material X located at the ground potential. Cations are accelerated by the potential difference of the ion sheath, and plasma treatment can be performed on the surface of the treated base material X by the plasma containing high energy cations.

### [Bias electrode]

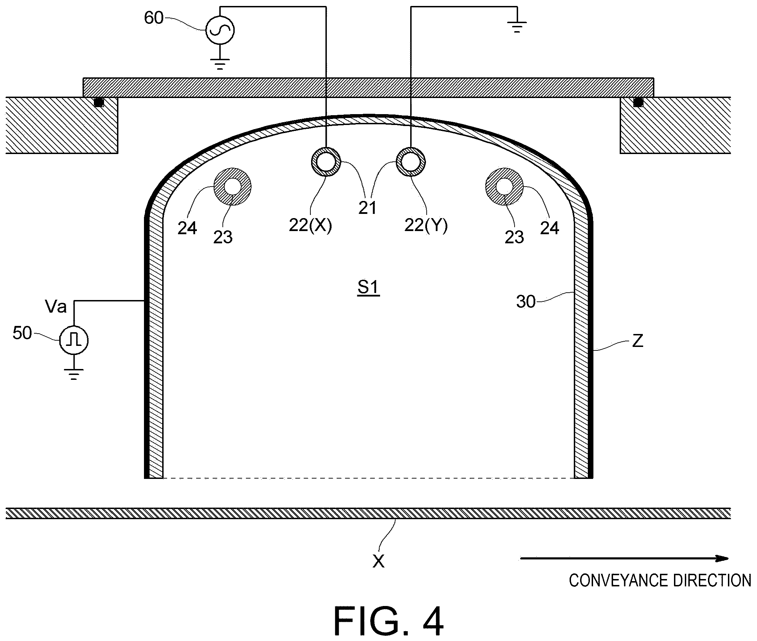

As shown in FIG. 4, the bias electrode 30 is provided around the plasma generation region. Here, the bias electrode 30 is a lidless box structure that surrounds the plasma generation region and is arranged to face the treated base material X in a structure that covers the linear antenna 20. While the discharge plasma excited by the linear antenna 20 is diffused in the plasma generation region between the linear antenna 20 and the treated base material X, the discharge plasma can be confined in the box-shaped bias electrode 30, and diffusion to the outside can be suppressed. Removal or cleaning of attachments to an inner surface of the treatment chamber, a vacuum container, or the like, due to diffusion of the discharge plasma so far, for example, a DLC film or the like, was major maintenance issues. Due to the disclosure, the discharge plasma is confined within the bias electrode, so that the attachments associated with the plasma reaction can be significantly reduced.

### [Bias voltage]

The bias voltage is not particularly limited and may be a DC voltage, a pulse voltage, an AC voltage, or a pulsating current voltage obtained by half-wave rectifying the AC voltage according to plasma treatment contents. In the case of the pulse voltage and the pulsating current voltage, the frequency is preferably 1 kHz to 100 kHz, for example.

### [High frequency current]

Since the high frequency power supply 60 (see FIG. 2) is provided to excite the discharge plasma in the vicinity of the antenna conductor 22, the frequency is not particularly limited to 13.56 MHz. In an embodiment, it is preferably the high frequency voltage of 300 kHz or more used in this specification. In addition, the bias power supply 50 is for controlling the potential of the high density plasma in the treatment chamber, and is a power supply capable of supplying a positive bias voltage. For example, in an embodiment, preferably, it can supply a positive pulse voltage, a positive AC voltage, or a pulsating current voltage obtained through half-wave rectification. Further, if the pressure of the working gas is several Pa or more, the discharge plasma can be excited only by the pulse voltage or the low frequency AC voltage. In this case, the high frequency power supply and the matching circuit are unnecessary.

### [Inductance]

In addition, inductance of the U-shaped antenna conductor 22 that constitutes a parallel flat plate type round-trip circuit is substantially proportional to a length of the U-shaped antenna conductor 22 and an interval between both the antenna conductors 22.

### [Plasma density]

The impedance of the linear antenna 20 in the longitudinal direction can be changed by changing the interval between both the antenna conductors at arbitrary positions of the power-feed-side antenna conductor 22X and the ground-side antenna conductor 22Y in the longitudinal direction. When the high frequency current flows to the antenna conductor 22, high frequency electric power consumption is large in the high impedance part of the antenna conductor 22, and electromagnetic field energy is also increased. Accordingly, a plasma density distribution of the plasma excited in the treatment chambers C1, C2 and C3 in the longitudinal direction of the antenna conductor 22 can be controlled, and a uniform plasma density distribution can be obtained.

### [Base material heating method]

According to the disclosure, the treated base material X or the like can be effectively heated by disposing a heating heater 23 that is the heating part 23 in the bias electrode 30. If a metal plate having a large inner thermal emissivity and a small outer thermal emissivity is used as the bias electrode material, the radiant heat of the heating heater 23 can be utilized extremely effectively. For example, an aluminum or aluminum alloy plate with a thermal emissivity of about 0.05 may be used.

For example, if an aluminum alloy plate with a thermal emissivity of about 0.05 is used, and the bias electrode coated with a conductive black body material with a thermal emissivity of about 0.9, such as carbon black or the like, is used on the inner side surface, most of the radiant heat emitted from the heating heater 23 is consumed in heating the bias electrode 30 and the treated base material X. When the thermal emissivity inside the bias electrode 30 is increased, it is extremely effective in heating the treated base material X. Further, since the heat radiation loss from the outer side surface of the bias electrode 30 can be significantly suppressed, a temperature rise of the treatment chamber can also be significantly reduced. Further, like mounting of the linear antenna 20 as shown in FIG. 3, the heating heater 23 can be mounted in a quartz tube 24 passing through the sidewalls of the plasma treatment chamber. The number, attachment positions, and the like, of the heating heaters 23 are not particularly limited and may be set according to treatment purposes. In addition, it is not limited to the embodiment and the entire the heating heater 23 may be accommodated in the plasma treatment chamber.

Further, according to the disclosure, by coating the outer side of the bias electrode with an insulating film Z, for example, a silicon oxide film an alumina film, or the like, occurrence of abnormal discharge between the treated base material in the ground potential and peripheral equipment such as the treatment chamber can be suppressed..

### [R to R method]

An example of a roll-to-roll type (R to R type) according to the disclosure will be described with reference to FIG. 1. FIG. 1 is a schematic cross-sectional view showing the plasma treatment apparatus 100 from above and a conceptual view of an R to R type in-line plasma treatment apparatus in which the plurality of plasma treatment chambers C1, C2 and C3 are connected. A load chamber 31 and an unload chamber 32 are provided on left and right sides of the treatment chambers C1, C2 and C3 of the plasma treatment apparatus 100. The treated base material X is wound on a feed roll 33 and stored in the load chamber 31, sequentially conveyed into the treatment chambers C1, C2 and C3 by the conveyance part 10, and treated by a plasma treatment part. The treated base material X, which was treated, is wound and stored on a wind-up roll 34 stored in the unload chamber 32 by the conveyance part 10 and carried out to the outside as products periodically.

The in-line type plasma treatment apparatus 100 shown in FIG. 1 has the three treatment chambers C1, C2 and C3. For example, the surface of the base material X can be cleaned by ion irradiation in the first treatment chamber C1, formation of a thin film such as DLC or the like can be performed in the second treatment chamber C2, and, for example, functional surface treatment can be performed in the third treatment chamber C3. Of course, the plasma treatment apparatus 100 according to the disclosure may include a single treatment chamber.

The load chamber 31 and the unload chamber 32 are kept at high vacuum by an exhaust part. In addition, the insides of the treatment chambers C1, C2 and C3 are connected via a differential exhaust system 40. That is, the plasma treatment apparatus 100 is the in-line type plasma treatment apparatus in which the plurality of treatment chambers C1, C2 and C3 are connected, and front and rear sides of the treatment chambers C1, C2 and C3 are connected via a differential exhaust chamber C4 connected to the differential exhaust system 40. A working gas is introduced into each of the treatment chambers C1, C2 and C3 by a working gas introduction part (not shown), and a predetermined gas pressure is adjusted to, for example, 0.7 Pa. Further, the bias power supply 50 according to the plasma treatment process is provided for each of the treatment chambers C1, C2 and C3.

Further, in each treatment chamber, sizes of the treatment chambers C1, C2 and C3, the number of the linear antennae 20 mounted, the size of the antenna conductor 21, and the like, can be designed arbitrarily according to plasma treatment contents.

When the plurality of plasma treatment processes is continuously performed in this way, the plurality of treatment chambers C1, C2 and C3 may be connected as shown in FIG. 1, and different plasma treatment can be performed for each of the treatment chambers C1, C2 and C3. That is, the plurality of types of plasma treatment can be simultaneously continuously performed by grounding the treated base material X, introducing a working gas necessary for each of the treatment chambers C1, C2 and C3 to adjust a gas pressure, and supplying different bias voltages for each of the treatment chambers C1, C2 and C3 to the bias electrode 30. Since the dedicated treatment chambers C1, C2 and C3 and the treatment condition can be set for each of the plasma treatment process, it is possible to achieve improvement of productivity and improvement of quality of products.

In the in-line type plasma treatment apparatus 100 according to the disclosure, as shown in FIG. 1, conveyance of the treated base material X between the treatment chambers C1, C2 and C3 can be performed through a substrate conveyance slit provided in the differential exhaust chamber C4. Each of the treatment chambers C1, C2 and C3 includes the working gas introduction part (not shown) and the differential exhaust system 40. Accordingly, mixing of working gases between the treatment chambers C1, C2 and C3 need not be considered.

In addition, when the plurality of plasma treatment processes having different treatment times is performed, it is difficult to convey the base material at a fixed speed. In this case, it is possible to employ an in-line type by intermittently conveying the base material.

It will be apparent to those skilled in the art that various modifications and variations can be made to the disclosed embodiments without departing from the scope of the disclosure.

## Claims

1. A plasma treatment apparatus (100), comprising:
a plasma treatment chamber (C1, C2, C3) in which a treated base material is accommodated;
a conveyance part (10) configured to convey the treated base material (X) into the plasma treatment chamber (C1, C2, C3);
an inductive coupling linear antenna (20) configured to generate plasma;
a bias electrode (30) configured to apply a bias voltage to the plasma; and
a heating part (23) configured to heat the treated base material,
wherein a cross section of the bias electrode cut perpendicularly to a longitudinal direction has a dome-shaped or U-shaped box shape, **characterized in that** the inductive coupling linear antenna (20) and the heating part (23) are disposed substantially in parallel in the bias electrode (30) in the longitudinal direction of the bias electrode (30).

2. The plasma treatment apparatus (100) according to claim 1, wherein the inductive coupling linear antenna (20) is constituted by a quartz tube (21) passing through sidewalls (111) facing each other of the plasma treatment chamber and an inductive coupling linear antenna conductor (22) inserted into the quartz tube (21).

3. The plasma treatment apparatus (100) according to claim 1, wherein one or a plurality of the inductive coupling linear antennas (20) substantially perpendicular to a conveyance direction of the treated base material (X) are attached substantially in parallel.

4. The plasma treatment apparatus (100) according to claim 1, wherein thermal emissivity of an outer surface of the dome-shaped or U-shaped bias electrode (30) is less than 0.3.

5. The plasma treatment apparatus (100) according to claim 1, wherein a material of the bias electrode (30) is aluminum or an aluminum alloy.

6. The plasma treatment apparatus (100) according to claim 1, wherein an outer surface of the bias electrode (30) is coated with an insulation film.

7. The plasma treatment apparatus (100) according to claim 1, wherein the bias electrode (30) is connectable to a pulse power supply (50) configured to generate at least one of a positive pulse voltage and a negative pulse voltage.

8. The plasma treatment apparatus (100) according to claim 1, which is an in-line type plasma treatment apparatus in which a plurality of the plasma treatment chambers (C1, C2, C3) are connected, wherein front and rear sides of the plasma treatment chamber are connectable via a differential exhaust chamber connected to a differential exhaust system.

## Patentansprüche

1. Plasmabehandlungsvorrichtung (100), aufweisend:
eine Plasmabehandlungskammer (C1, C2, C3), in der ein behandeltes Basismaterial aufgenommen ist;
ein Förderteil (10), das konfiguriert ist, um das behandelte Basismaterial (X) in die Plasmabehandlungskammer (C1, C2, C3) zu fördern;
eine induktive Kopplungslinearantenne (20), die konfiguriert ist, um Plasma zu erzeugen;
eine Vorspannungselektrode (30), die konfiguriert ist, um eine Vorspannung an das Plasma anzulegen; und
ein Heizteil (23), das konfiguriert ist, um das behandelte Basismaterial zu erwärmen,
wobei ein Querschnitt der Vorspannungselektrode, der senkrecht zu einer Längsrichtung geschnitten ist, eine kuppelförmige oder U-förmige Kastenform aufweist, **dadurch gekennzeichnet, dass** die induktive Kopplungslinearantenne (20) und das Heizteil (23) im Wesentlichen parallel in der Vorspannungselektrode (30) in der Längsrichtung der Vorspannungselektrode (30) angeordnet sind.

2. Plasmabehandlungsvorrichtung (100) nach Anspruch 1, wobei die induktive Kopplungslinearantenne (20) durch ein Quarzrohr (21), das durch einander zugewandte Seitenwände (111) der Plasmabehandlungskammer verläuft, und einen induktiven Kopplungslinearantennenleiter (22), der in das Quarzrohr (21) eingesetzt ist, gebildet ist.

3. Plasmabehandlungsvorrichtung (100) nach Anspruch 1, wobei eine oder eine Vielzahl der induktiven Kopplungslinearantennen (20), die im Wesentlichen senkrecht zu einer Förderrichtung des behandelten Basismaterials (X) sind, im Wesentlichen parallel angebracht sind.

4. Plasmabehandlungsvorrichtung (100) nach Anspruch 1, wobei ein thermischer Emissionsgrad einer Außenfläche der kuppelförmigen oder U-förmigen Vorspannungselektrode (30) weniger als 0,3 beträgt.

5. Plasmabehandlungsvorrichtung (100) nach Anspruch 1, wobei ein Material der Vorspannungselektrode (30) Aluminium oder eine Aluminiumlegierung ist.

6. Plasmabehandlungsvorrichtung (100) nach Anspruch 1, wobei eine Außenfläche der Vorspannungselektrode (30) mit einem Isolierfilm beschichtet ist.

7. Plasmabehandlungsvorrichtung (100) nach Anspruch 1, wobei die Vorspannungselektrode (30) mit einer Impulsstromversorgung (50) verbindbar ist, die konfiguriert ist, um mindestens eine von einer positiven Impulsspannung und einer negativen Impulsspannung zu erzeugen.

8. Plasmabehandlungsvorrichtung (100) nach Anspruch 1, die eine Plasmabehandlungsvorrichtung vom Inline-Typ ist, in der eine Vielzahl der Plasmabehandlungskammern (C1, C2, C3) verbunden sind, wobei Vorder- und Rückseiten der Plasmabehandlungskammer über eine Differenzialabgaskammer verbindbar sind, die mit einem Differenzialabgassystem verbunden ist.

## Revendications

1. Appareil de traitement au plasma (100) comprenant :
une chambre de traitement au plasma (C1, C2, C3) dans laquelle un matériau de base traité est logé ;
une partie de transport (10) configurée pour transporter le matériau de base traité (X) jusque dans la chambre de traitement au plasma (C1, C2, C3) ;
une antenne linéaire à couplage inductif (20) configurée pour générer un plasma ;
une électrode de polarisation (30) configurée pour appliquer une tension de polarisation au plasma ; et
une partie chauffante (23) configurée pour chauffer le matériau de base traité,
dans lequel une section transversale de l'électrode de polarisation coupée perpendiculairement à une direction longitudinale possède une forme de boîte en forme de dôme ou en forme de U, **caractérisé en ce que** l'antenne linéaire à couplage inductif (20) et la partie chauffante (23) sont disposées sensiblement en parallèle dans l'électrode de polarisation (30) dans la direction longitudinale de l'électrode de polarisation (30).

2. Appareil de traitement au plasma (100) selon la revendication 1, dans lequel l'antenne linéaire à couplage inductif (20) est constituée d'un tube en quartz (21) traversant des parois latérales (111) l'une en face de l'autre de la chambre de traitement au plasma et d'un conducteur d'antenne linéaire à couplage inductif (22) inséré dans le tube en quartz (21).

3. Appareil de traitement au plasma (100) selon la revendication 1, dans lequel l'une ou une pluralité des antennes linéaires à couplage inductif (20), sensiblement perpendiculaires à une direction de transport du matériau de base traité (X), sont fixées sensiblement en parallèle.

4. Appareil de traitement au plasma (100) selon la revendication 1, dans lequel l'émissivité thermique d'une surface externe de l'électrode de polarisation (30) en forme de dôme ou en forme de U est inférieure à 0,3.

5. Appareil de traitement au plasma (100) selon la revendication 1, dans lequel un matériau de l'électrode de polarisation (30) est l'aluminium ou un alliage d'aluminium.

6. Appareil de traitement au plasma (100) selon la revendication 1, dans lequel une surface externe de l'électrode de polarisation (30) est revêtue d'un film isolant.

7. Appareil de traitement au plasma (100) selon la revendication 1, dans lequel l'électrode de polarisation (30) est apte à être connectée à une alimentation électrique par impulsions (50) configurée pour générer au moins l'une parmi une tension d'impulsion positive et une tension d'impulsion négative.

8. Appareil de traitement au plasma (100) selon la revendication 1, qui est un appareil de traitement au plasma de type en ligne dans lequel une pluralité des chambres de traitement au plasma (C1, C2, C3) sont raccordées, dans lequel les côtés avant et arrière de la chambre de traitement au plasma sont aptes à être raccordés via une chambre d'échappement différentielle raccordée à un système d'échappement différentiel.
